Europäisches Patentamt

European Patent Office

Office européen des brevets

(19)

(11) Veröffentlichungsnummer: **0 335 220 B1**

(12) **EUROPÄISCHE PATENTSCHRIFT**

(45) Veröffentlichungstag der Patentschrift: **27.10.93**

(51) Int. Cl.⁵: **G03F 7/022**

(21) Anmeldenummer: **89104978.5**

(22) Anmeldetag: **20.03.89**

(54) **Positiv arbeitendes lichtempfindliches Gemisch und daraus hergestelltes Aufzeichnungsmaterial mit hohem Wärmestand.**

(30) Priorität: **29.03.88 DE 3810631**

(43) Veröffentlichungstag der Anmeldung:
**04.10.89 Patentblatt 89/40**

(45) Bekanntmachung des Hinweises auf die
Patenterteilung:
**27.10.93 Patentblatt 93/43**

(84) Benannte Vertragsstaaten:
**BE CH DE FR GB LI**

(56) Entgegenhaltungen:
**EP-A- 0 070 624**
**EP-A- 0 231 855**
**EP-A- 0 239 423**

(73) Patentinhaber: **HOECHST AKTIENGESELL-
SCHAFT**

**D-65926 Frankfurt(DE)**

(72) Erfinder: **Schmitt, Axel, Dr.
Lärchenweg 5
D-6229 Walluf(DE)**
Erfinder: **Zahn, Wolfgang, Dr.
Goetheweg 3
D-6228 Eltville 2(DE)**
Erfinder: **Behrens, Burkhard, Dr.
Am Hohen Stein 24
D-6200 Wiesbaden(DE)**

**Beschreibung**

Die Erfindung betrifft ein positiv arbeitendes lichtempfindliches Gemisch, enthaltend als lichtempfindliche Verbindung ein o-Chinondiazid sowie ein in Wasser unlösliches, in wäßrigem Alkali lösliches Bindemittel vom Novolak-Typ.

Durch die fortschreitende Miniaturisierung in der Halbleitertechnik steigen sowohl die Anforderungen an das Auflösungsvermögen von lichtempfindlichen Mischungen wie auch die Anforderungen an die Techniken zu deren Verarbeitung. Wegen ihres höheren Auflösungsvermögens finden die positiv arbeitenden lichtempfindichen Gemische zunehmend gegenüber den negativ arbeitenden an Bedeutung. Die zu Unterätzungen führenden, isotrop wirkenden Naßätzverfahren werden in zunehmendem Maße von den anistropen Trockenätzverfahren - wie Plasmaätzen und reaktives Ionenätzen - verdrängt. Diese neuen Verfahren stellen zusätzlich Anforderungen an die Eigenschaften der lichtempfindlichen Mischungen (Photoresists), insbesondere hinsichtlich der Plasmaätzbeständigkeit und ihrer Wärmestabilität.

Bekannt sind positiv arbeitende lichtempfindliche Mischungen, enthaltend Verbindungen, die bei Belichtung Säure freisetzen, in Kombination mit durch Säure spaltbare Verbindungen, z.B. Acetalen und Orthocarbonsäureestern sowie größere Mengenanteile an Novolakharzen.

Lichtempfindliche Gemische dieser Art sind in den EP-A-0 022 571, 0 006 626, 0 006 627 und 0 202 196; den DE-A-26 10 842, 35 44 165 und 36 01 264; den DE-C-23 06 248 und 27 18 254 sowie den Deutschen Patentanmeldungen P 37 30 083.5 und P 37 30 785.1 genannt.

Vorwiegend werden aber lichtempfindliche Gemische beschrieben, die als lichtempfindliche Verbindung ein o-Chinondiazid enthalten und als Bindemittel vorwiegend Phenol- oder Kresol-Novolakharze aufweisen.

Aus der Patentliteratur sind zahlreiche Beispiele bekannt, wie die photolithographischen Eigenschaften eines lichtempfindlichen Gemisches durch Modifizierung des in wäßrigem Alkali löslichen Bindemittels beeinflußt werden können. Als Kriterien werden in der Regel das Auflösungsvermögen, die Entwicklerresistenz, der Kontrast sowie die Lichtempfindlichkeit genannt.

Eine höhere Lichtempfindlichkeit in positiv arbeitenden lichtempfindlichen Gemischen soll z.B. auch durch Wahl bestimmter Gemische aus m-/p-Kresol bzw. m/p- und o-Kresol erreicht werden können (EP-A-0 070 624).

Hohe Auflösung als Folge von Reliefmustern mit steilen Kantenprofilen sollen bei positiv arbeitenden lichtempfindlichen Gemischen durch Wahl bestimmter m-/p-Kresolgemische erzielt werden (DE-A-36 26 582).

Auch mit den positiv arbeitenden lichtempfindlichen Gemischen aus der DE-A-36 03 372 sollen steile Kantenprofile erreicht werden können, diesmal durch Wahl eines Novolak-Harzes, das aus m-/p-Kresol in Kombination mit 2,5-Xylenol besteht.

Novolak-Harze bestehend aus m-/p-Kresolgemischen in Kombination mit Xylenolen und kondensiert mit Aldehyden werden auch in der JP-A-16 4740/1985 beschrieben. Hier soll das lichtempfindliche Gemisch, das ebenso positiv arbeitend ist, eine verbesserte Entwicklungsresistenz und eine hohe Lichtempfindlichkeit aufweisen.

Die bisher genannten positiv arbeitenden lichtempfindlichen Gemische lassen allerdings eine hohe Wärmestabilität (-stand) des jeweiligen Resists vermissen.

Abhilfe sollen Novolak-Harze höheren Molekulargewichts schaffen, die aus monoalkylierten Alkylphenolen bestehen, deren Alkylgruppen in m- oder p-Stellung zu phenolischen Hydroxylgruppen stehen und damit bireaktiv (gegenüber nukleophilen Reagenzien) sind (DE-A-26 16 992).

Ebenso sollen Novolakharze in positiv arbeitenden lichtempfindlichen Gemischen, die aus m-Kresol-Formaldehydharzen mit Molekulargewichten von 5.000 bis 30.000 bestehen, eine hohe Wärmestabilität sowie eine gute Lichtempfindlichkeit aufweisen (JP-A-57339/1985). Gemische dieser Art zeigen jedoch eine unbefriedigende Entwicklerresistenz z.B. gegenüber metallionenfreien Entwicklern.

Einen erhöhten Wärmestand sollen auch lichtempfindliche Gemische besitzen, die als Bindemittel reine m-Kresol-Novolakharze enthalten, allerdings mit einem mittleren Molekulargewicht und einer niedrigen Polydispersität. Allerdings weisen auch Gemische dieser Art hohe Dunkelabträge in metallionenfreien Entwicklern auf.

Novolakharze von m-Kresol mit anderen Alkylphenolen mit bestimmter Molekulargewichtsverteilung werden in der EP-A-0 239 423 beschrieben. Auch hier soll der Wärmestand hoch sein, ebenso die Lichtempfindlichkeit, aber auch die Auflösung soll gut sein.

Der bisher genannte Stand der Technik beschreibt Novolakharze, die als Monomerbausteine neben m-Kresol immer bi- bzw. trireaktive Phenole enthalten, da zum Aufbau einer Polykondensatkette eben mindestens bireaktive Monomere neben der Aldehyd- bzw. Ketonkomponente notwendig sind.

In der EP-A-0 239 423 werden zum ersten Mal neben dem bekannten m-Kresol auch monoreaktive Phenole wie 2,4- bzw. 2,6-Dimethylphenol als Monomere zum Aufbau von Novolakharzen genannt. Positiv arbeitende lichtempfindliche Gemische, enthaltend diese Harze als Bindemittel, zeigen jedoch in metallionenfreien Entwicklerlösungen einen sehr hohen Dunkelabtrag. Ein zu hoher Dunkelabtrag verringert aber die Differenzierbarkeit zwischen belichteten und unbelichteten Bereichen des Aufzeichnungsmaterials und damit den Entwicklungskontrast.

Es bestand daher die Aufgabe, ein positiv arbeitendes lichtempfindliches Gemisch bereitzustellen, das einen hohen Wärmestand sowie einen niedrigeren Dunkelabtrag bei Entwicklung mit einem metallionenfreien Entwickler aufweist.

Die Aufgabe wird gelöst mit einem positiv arbeitenden Gemisch der eingangs beschriebenen Art, das dadurch gekennzeichnet ist, daß es als in wäßrigem Alkali lösliches Bindemittel ein Novolakharz enthält, das aus einem Gemisch aus m-Kresol und einem 2,3,6-Trialkylphenol hergestellt worden ist.

Es war völlig überraschend, daß durch Zugabe von einem monoreaktiven Phenol wie einem 2,3,6-Trialkylphenol neben einem hohen Wärmestand auch ein niedriger Dunkelabtrag bei Entwicklung mit einem metallionenfreien Entwickler erzielt werden kann.

Dies umsomehr, als Harze mit anderen monoreaktiven Phenolkomponenten dieses Eigenschaftsprofil nicht aufweisen (vgl. EP-A-0 239 423)

Der Wärmestand wird im allgemeinen durch die Glastemperatur des Harzes bestimmt. Die in den erfindungsgemäßen lichtempfindlichen Gemischen enthaltenen Novolak Harze weisen eine Glastemperatur von mindestens 110° C auf. Besonders bevorzugt sind Glastemperaturen von mindestens 115° C.

Die in den erfindungsgemäßen lichtempfindlichen Gemischen enthaltenen Novolakharze werden in der bevorzugten Ausführungsform aus einem Gemisch, enthaltend 75 - 95 mol-% m-Kresol sowie 2,3,6-Trialkylphenol, insbesondere zu 5 - 25 mol-%, hergestellt. Besonders bevorzugt sind Herstellungsgemische, enthaltend 80 - 92 mol-% m-Kresol und 8 - 20 mol-% 2,3,6-Trialkylphenole. Steigt der Gehalt an 2,3,6-Trialkylphenolen über 25 mol-%, so wird es schwierig, daraus ein Novolakharz herzustellen, das einen ausreichend hohen Kondensationsgrad aufweist (da es sich um ein monoreaktives Derivat handelt).

Insbesondere sind bevorzugt 2,3,6-Trialkylphenole, deren gleiche oder verschiedene Alkylgruppen ($C_1$-$C_3$)Alkyl entsprechen, insbesondere aber ist Alkyl gleich Methyl.

Zur Herstellung der im erfindungsgemäßen lichtempfindlichen Gemisch enthaltenen Novolak-Harze werden die beschriebenen Phenolgemische mit Carbonylkomponenten kondensiert. Als Carbonylverbindungen werden z.B. Formaldehyd, dessen Derivate wie Paraformaldehyd und Trioxan, Acetaldehyd, Propylaldehyd, Acrolein, Benzaldehyd, 4-Hydroxybenzaldehyd, Aceton, Methylethylketon, Diethylketon, Methylisobutylketon, Acetophenon, Benzylmethylketon u.a. verwendet. Sie werden einzeln, aber auch in Mischung eingesetzt. Ebenso werden die Acetale der obengenannten Carbonylverbindungen verwendet.

Besonders bevorzugt sind aber Formaldehyd und Paraformaldehyd.

Das Molverhältnis der Carbonylkomponente(n) zu der eingesetzten Phenolkomponente(n) beträgt 0,80 bis 0,93 zu 1 (Einstand). Vorzugsweise wird ein Verhältnis von 0,9 Mol : 1 Mol (Carbonylkomponente : Phenolkomponente) eingesetzt.

Üblicherweise enthält das Gemisch zur Herstellung der in den erfindungsgemäßen lichtempfindlichen Gemischen enthaltenen Novolakharze eine Säure als Katalysator. Hierunter zählen sowohl organische Säuren wie z.B. Maleinsäureanhydrid, Oxalsäure, Ameisensäure, Essigsäure, Trifluoressigsäure, Methansulfonsäure und Toluolsulfonsäure als auch anorganische Säuren, wie z.B. Schwefelsäure und Phosphorsäure. Bevorzugt ist die Oxalsäure.

Die Säuren werden in Mengen von $10^{-4}$ bis $10^{-1}$ mol pro mol Phenolverbindung, insbesondere von $10^{-3}$ bis $5 \times 10^{-2}$ mol, eingesetzt.

Vorteilhaft wird die Kondensation zwischen den Phenolkomponenten und der Carbonylkomponente in Gegenwart von Lösemitteln durchgeführt. Der Siedepunkt des Lösemittels liegt bei 120 bis 200° C, insbesondere bei 140 bis 190° C. Diese Lösemittel müssen ein gutes Lösungsvermögen für Novolakharze besitzen. Als Lösemittel werden Glykolether - wie Methylglykol, Ethylglykol, Butylglykol -, Methoxybutanol, Dimethylformamid, Diethylenglykoldimethylether, Ethylglykolacetat, Methylpropylenglykolacetat eingesetzt. Vorzugsweise werden hydroxylgruppenfreie Lösungsmittel verwendet und in Mengen von 0,2 bis 1,0 Gewichtsteilen (Gt) pro Gewichtsteil Phenolgemisch eingesetzt.

Als lichtempfindliche Verbindung im erfindungsgemäßen lichtempfindlichen Gemisch werden o-Chinondiazide genannt, die als einheitliche Verbindungen sowie in Form von Gemischen eingesetzt werden. Vorzugsweise sind die aromatischen und aliphatischen Amide und Ester von o-Naphtho- bzw. o-Benzochinondiaziden zu nennen. Bis-1,2-naphthochinon-2-diazidsulfonsäureamide werden z.B. in der EP-A-0 231 855 beschrieben. Bevorzugt sind allerdings die Ester von Mono- und Polyhydroxybenzophenonen, Mono- und Polyhydroxyacylophenonen, Gallussäuren, Phloroglucin, Mono- und Polyhydroxydiphenylmethanen und Bis-

(hydroxyphenyl)valeriansäure zu nennen. Bevorzugt sind die Ester der Polyhydroxybenzophenone bzw. Polyhydroxyacylophenone. Besonders bevorzugt sind die Trihydroxyverbindungen, insbesondere Trihydroxybenzophenon, und hierunter wiederum die Trisester von o-Naphtho- bzw. o-Benzochinondiazidsulfonsäuren. Infrage kommen die Diazid-4- und -5-sulfonsäureester, aber auch gemischte Ester, insbesondere Trisester aus den 4- und 5-Sulfonsäuren. Verbindungen dieses Typs sind in den DE-C-938 239, 21 31 377, 25 47 905 und 28 28 017 beschrieben.

Das erfindungsgemäße lichtempfindliche Gemisch enthält auf 100 Gewichtsteile des Novolakharzes 5 bis 100 Gewichtsteile o-Chinondiazid, insbesondere 10 bis 60 Gewichtsteile. Bezogen auf das lichtempfindliche Gemisch ist das Novolakharz zu 1 bis 90, insbesondere zu 50 bis 90 Gew.-%, enthalten.

Ferner können den erfindungsgemäßen lichtempfindlichen Gemischen ggf. Farbstoffe, Pigmente, Netzmittel und Verlaufmittel zur Verbesserung spezieller Erfordernisse wie Flexibilität, Haftung und Glanz zugesetzt werden.

Vorzugsweise wird das erfindungsgemäße lichtempfindliche Gemisch in Lösungsmitteln wie Ethylenglykol, Glykolethern wie Glykolmonomethylether, Glykoldimethylether, Glykolmonoethylether oder Propylenglykolmonoalkylethern, insbesondere Propylenglykolmethylether; aliphatischen Estern wie Ethylacetat, Hydroxyethylacetat, Alkoxyethylacetat, γ-Butylacetat, Propylenglykolmonoalkyletheracetat, insbesondere Propylenglykolmethyletheracetat oder Amylacetat; Ethern wie Dioxan, Ketonen wie Methylethylketon, Methyliso-butylketon, Cyclopentanon und Cyclohexanon; Dimethylformamid, Dimethylacetamid, Hexamethylphosphorsäureamid, N-Methylpyrrolidon, Butyrolacton, Tetrahydrofuran, und in Mischungen derselben gelöst. Besonders bevorzugt werden Glykolether, aliphatische Ester sowie Ketone.

Die mit den übrigen Bestandteilen des lichtempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein lichtempfindliches Aufzeichnungsmaterial beansprucht, im wesentlichen bestehend aus einem Substrat und dem darauf aufgetragenen lichtempfindlichen Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus reinen Siliciumschichten und thermisch oxidiertem und/oder mit Aluminium beschichtetem Siliciummaterial zu nennen, die gegebenenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, gegebenenfalls mit Aluminium beschichtete $SiO_2$-Materialien und Papier. Diese Substrate können einer Temperatur-Vorbehandlung unterzogen werden, oberflächlich angerauht, angeätzt oder zur Erzielung erwünschter Eigenschaften, wie z. B. Erhöhung der Hydrophilie, mit Chemikalien behandelt sein.

In einer besonderen Ausführungsform kann das lichtempfindliche Gemisch zur besseren Haftung in dem Resist oder zwischen dem Resist und dem Substrat einen Haftvermittler enthalten. Bei Silicium- bzw. Siliciumdioxid-Substraten kommen hierfür Haftvermittler vom Aminosilantyp, wie z.B. 3-Aminopropyl-triethoxysilan oder Hexamethyl-disilazan in Frage.

Beispiele für Träger, die zur Herstellung von photomechanischen Aufzeichnungsschichten wie Druckformen für den Hochdruck, den Flachdruck, den Siebdruck, den Tiefdruck sowie von Reliefkopien Verwendung finden können, sind Aluminiumplatten, ggf. anodisch oxidiert, gekörnte und/ oder silikatisierte Aluminiumplatten, Zinkplatten, Stahlplatten, die ggf. mit Chrom bearbeitet wurden, sowie Kunststoffolien oder Papier.

Das erfindungsgemäße Aufzeichnungsmaterial wird bildmäßig belichtet. Quellen aktinischer Strahlung sind: Metallhalogenidlampen, Kohlebogenlampen, Xenonlampen und Quecksilberdampflampen. Ebenso kann eine Belichtung mit energiereicher Strahlung wie Laser-, Elektronen-oder Röntgenstrahlung erfolgen.

Die Schichtstärke variiert in Abhängigkeit von ihrem Einsatzgebiet. Sie beträgt zwischen 0,1 und 100 μm, insbesondere zwischen 0,3 und 10 μm.

Gegenstand der Erfindung ist ferner ein Verfahren zur Herstellung eines lichtempfindlichen Aufzeichnungsmaterials. Das Auftragen des lichtempfindlichen Gemisches auf das Substrat kann durch Aufsprühen, Fließbeschichten, Walzen, Schleuderbeschichten und Tauchbeschichten erfolgen. Danach wird das Lösungsmittel durch Verdampfen entfernt, so daß auf der Oberfläche des Substrates die lichtempfindliche Schicht zurückbleibt. Die Entfernung des Lösemittels kann gegebenenfalls durch Erhitzen der Schicht auf Temperaturen von bis zu 140° C gefördert werden. Das Gemisch kann aber auch zunächst auf obengenannte Weise auf den Zwischenträger aufgetragen werden, von dem aus es unter Druck und erhöhter Temperatur auf das endgültige Trägermaterial übertragen wird.

Anschließend wird die Schicht bildmäßig belichtet. Üblicherweise wird aktinische Strahlung verwendet. Zur Bestrahlung werden UV-Lampen verwendet, die Licht einer Wellenlänge von 200 bis 500 nm aussenden. In der lichtempfindlichen Schicht wird anschließend durch Entwicklung ein Bildmuster freigelegt, indem die Schicht mit einer Entwicklungslösung behandelt wird, die die bestrahlten Bereiche des Materials löst bzw. entfernt.

Als Entwickler werden Lösungen von Reagenzien wie z.B. Silikaten, Metasilikaten, Hydroxiden, Hydrogen- bzw. Dihydrogenphosphaten, Carbonaten bzw. Hydrogencarbonaten, von Alkali und/oder Erdalkali, insbesondere von Ammoniumionen, aber auch Ammoniak und dergleichen verwendet. Metallionenfreie Entwickler werden in der US-A-4,729,941, der EP-A-0 062 733, der US-A-4,628,023, der US-A-4,141,733, der EP-A-0 097 282 und der EP-A-0 023 758 beschrieben. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung.

Die entwickelten Resiststrukturen werden ggf. nachgehärtet. Dies geschieht im allgemeinen dadurch, daß man die Resiststruktur auf einer hot-plate bis zu einer Temperatur unter der Fließtemperatur erhitzt und anschließend mit UV-Licht einer Xenon-Quecksilber-Dampflampe (Bereich von 200 bis 250 nm) ganzflächig belichtet. Durch diese Nachhärtung werden die Resiststrukturen vernetzt, so daß die Strukturen eine Fließbeständigkeit im allgemeinen bis zu Temperaturen von über 200°C aufweisen. Die Nachhärtung kann auch ohne Temperaturerhöhung unter Einstrahlung von UV-Licht erfolgen. Dies gilt insbesondere dann, wenn energiereiche Strahlung verwendet wird, z.B. Elektronenstrahlung.

In folgenden Beispielen sollen die Vorteile des erfindungsgemäßen lichtempfindlichen Gemisches, enthaltend die beschriebenen Novolak-Harze, verdeutlicht werden.

Die Vergleichsbeispiele basieren einerseits auf

1) monoreaktiven Alkylphenolen (2,4- bzw. 2,6-Dimethylphenol) im Vergleich zum erfindungsgemäß eingesetzten, ebenso monoreaktiven 2,3,6-Trimethylphenol und

2) einem bireaktivem Alkylphenol (2,3,5-Trimethylphenol), das mit den erfindungsgemäß eingesetzten 2,3,6-Trimethylphenol die Anzahl der Substituenten gemeinsam hat.

Im Vergleich zu den monoreaktiven Vergleichs-Novolakharzen stellte sich überraschenderweise heraus, daß die erfindungsgemäß eingesetzten Novolakharze nicht nur den geforderten hohen Wärmestand (gemessen als Glastemperatur), sondern einen wesentlich niedrigeren Dunkelabtrag aufweisen. Die Ergebnisse sind in Tabelle 1 zusammengefaßt.

Im Vergleich zu dem bireaktiven 2,3,5-Trimethylphenol erlaubt das zwar monoreaktive, aber ebenso trisubstituierte 2,3,6-Trimethylphenol als Comonomer eine besser kontrollierbare und genauer reproduzierbare Herstellung der in den erfindungsgemäßen lichtempfindlichen Gemischen eingesetzten Novolakharze. Das zeigt sich besonders an der Abhängigkeit der Viskosität (dynamische Viskosität) eines herzustellenden Novolak-Harzes von der bei dieser Herstellung eingesetzten Menge an Carbonylverbindung. Während Gemische, die als Comonomere 2,3,6-Trimethylphenol enthalten auch bei einer größeren Schwankungsbreite der eingesetzten Menge an Carbonylverbindung jeweils relativ konstante Viskositätswerte zeigen, ist diese Abhängigkeit bei den 2,3,5-Trimethylphenol enthaltenden Gemischen wesentlich ausgeprägter. Die Ergebnisse sind in der Tabelle 2 zusammengefaßt.

Da bei der großtechnischen Synthese solcher Novolak-Harze immer mit Schwankungen der Eduktkonzentrationen, insbesondere der im Reaktionsgefäß örtlich unterschiedlichen, gerechnet werden muß, ist die Wahl von Komponenten, die trotz dieses Risikos in ihrer Qualität identische Produkte liefern, eindeutig vorzuziehen. Insbesondere ist eine einheitliche Produktqualität im Hinblick auf das Anwendungsgebiet der Novolakharze, der Photoresists, gefordert, da diese enge und spezifische lithographische Eigenschaftsprofile, die stark von der Qualität des Novolakharzes abhängen, aufweisen müssen.

In den folgenden Beispielen stehen Gewichtsteile (Gt) zu Volumenteilen (Vt) im Verhältnis $g:cm^3$, Prozentangaben und Mengenverhältnisse sind, wenn nicht anders angegeben ist, in Gewichtsteilen zu verstehen.

Beispiel 1

Herstellung des Bindemittels

In einem Vierhalskolben mit Rückflußkühler, Tropftrichter und Rührer werden 295 g m-Kresol und 41,3 g 2,3,6-Trimethylphenol in 193 ml Diethylenglykoldimethylether gelöst, mit 10 g Oxalsäuredihydrat versetzt und auf etwa 100°C erwärmt. Zu diesem Gemisch tropft man 222 g 37%ige wäßrige Formalinlösung und hält das Reaktionsgemisch weitere 6 Stunden bei schwachem Rückfluß. Anschließend werden Wasser, Lösungsmittel und nicht umgesetzte Ausgangskomponenten zunächst bei Normaldruck bis 200°C, dann im Wasserstrahlvakuum bis 220°C abdestilliert. Das heiße Novolakharz wird in eine Kühlpfanne entleert und erkalten gelassen.

Die Viskosität des Novolakharzes wird als dynamische Viskosität einer 40%igen Lösung des Novolaks in Methoxy-propanol gemessen. Sie beträgt 630 mPa x s, (T = 20° C) und wurde mit einem Kugelziehviskosimeter bestimmt.

Die Glastemperatur des Novolakharzes ist 119° C. Sie ist mit einem Differentialkalorimeter (DSC 1090 der Fa. Dupont) bei einer Heizrate von 20 K/min bestimmt und läßt sich aus der Temperatur der halben Stufenhöhe ermitteln.

Anwendung

Es werden Beschichtungslösungen hergestellt, enthaltend
a) 12 Gt des vorstehend beschriebenen Novolak-Harzes,
2 Gt des Umsetzungsproduktes aus 3 mol 1,2-Naphthochinondiazid-5-sulfonylchlorid und 1 mol Trihydroxybenzophenon in
45 Gt Propylenglykolmonomethyletheracetat und
b) die in a) angegebenen Komponenten mit der Ausnahme, daß anstelle des Trisesters von 1,2-Naphthochinondiazid-5-sulfonylchlorid der entsprechende Ester des -4-sulfonylchlorids eingesetzt wird.

Die Lösungen werden durch einen 0,2 $\mu$m-Filter (Millipore) filtriert und auf mit einem Haftvermittler (Hexamethyldisilizan) behandelte Siliciumwafer so aufgeschleudert, daß nach dem Trocknen bei 90° C für 30 min in einem Umluftofen Resistschichten von 1 $\mu$m Dicke erhalten werden.

Zur Bestimmung des Dunkelabtrags werden die beschichteten Siliciumwafer 60 sec lang mit einer 0,2 n metallionenfreien Entwicklerlösung, enthaltend Tetramethylammoniumhydroxid, entwickelt. Anschließend werden die Dicken der verbleibenden Resistschichten mit einem Rudolph-Schichtdickenmeßgerät gemessen. Der Schichtdickenverlust ergibt den Dunkelabtrag (nm/min) des lichtempfindlichen Schicht. Es konnten Dunkelabträge von 58 nm/min (a) und 47 nm/min (b) ermittelt werden.

Zur Ermittlung des Wärmestandes werden die beschriebenen lichtempfindlichen Gemische auf mit einem Haftvermittler behandelte Siliciumwafer so aufgetragen, daß nach Trocknung bei 90° C für 30 min Schichtdicken von 1,7 $\mu$m erhalten werden. Danach werden im Projektionsverfahren 2 $\mu$m breite Strukturelemente aufbelichtet und mit einem handelsüblichen wäßrig-alkalischen Entwickler entwickelt. Die so erhaltenen Resistmuster werden zur Prüfung auf Wärmestabilität für 30 min auf 150° C erwärmt und Veränderungen der Kantenprofile beobachtet. Sowohl für die Beispiele 1 und 2 wie auch für die Vergleichsbeispiele 1 bis 3 konnten keine Veränderungen der Kantenprofile festgestellt werden.

Beispiel 2

Herstellung des Bindemittels

432 g m-Kresol und 136 g 2,3,6-Trimethylphenol werden mit 300 g Diethylenglykoldimethylether und 11 g Oxalsäuredihydrat auf etwa 100° C erwärmt. Innerhalb einer Stunde werden 366 g 37%ige Formalinlösung (4,5 mol) zugetropft und das Reaktionsgemisch weitere 15 Stunden bei schwachem Rückfluß gehalten. Die Aufarbeitung erfolgt wie in Beispiel 1 angegeben.

Das Novolakharz besitzt eine Viskosität von 495 mPa x s (40%ig in Methoxypropanol) und eine Glastemperatur von 117° C.

Anwendung

Analog zu Beispiel 1 b) wird eine Resistlösung, enthaltend das Bindemittel aus Beispiel 2, auf einen Träger aufgeschleudert, getrocknet und der Dunkelabtrag nach Entwickeln mit dem in Beispiel 1 angegebenen metallionenfreien Entwickler bestimmt. Es konnte ein Dunkelabtrag von 18 nm/min ermittelt werden.

Vergleichsbeispiel 1

Herstellung des Bindemittels

Unter den in Beispiel 1 beschriebenen Reaktionsbedingungen wird ein Kresol-Xylenol-Gemisch, das aus m-Kresol und 2,4-Dimethylphenol im Molverhältnis 9:1 besteht, und Formaldehyd, zu einem Novolakharz mit einer Viskosität von 615 mPa x s (40%ig in Methoxypropanol) und einer Glastemperatur von 118° C umgesetzt.

Anwendung

Entsprechend Beispiel 1 werden Resistlösungen, aber enthaltend das Bindemittel aus Vergleichsbeispiel 1, auf Träger aufgeschleudert, getrocknet und die Dunkelabträge nach dem Entwickeln mit dem in Beispiel 1 angegebenen metallionenfreien Entwickler bestimmt. Es konnten Dunkelabträge von 272 nm/min (a) und 351 nm/min (b) ermittelt werden.

Vergleichsbeispiel 2

Herstellung des Bindemittels

Ein Kresol-Xylenol-Gemisch, bestehend aus m-Kresol und 2,6-Dimethylphenol im Molverhältnis 9:1, und Formaldehyd wird unter den in Beispiel 1 beschriebenen Reaktionsbedingungen zu einem Novolakharz mit einer Viskosität von 690 mPa x s (40%ig in Methoxypropanol) und einer Glastemperatur von 116° C kondensiert.

Anwendung

Analog zu Beispiel 1 werden Resistlösungen enthaltend das Bindemittel aus Vergleichsbeispiel 2 hergestellt und entsprechend zu Beispiel 1 die Dunkelabträge bestimmt. Sie wurden zu 289 nm/min (a) und 365 nm/min (b) ermittelt.

Vergleichsbeispiel 3

Herstellung des Bindemittels

m-Kresol und Formaldehyd werden unter den in Beispiel 1 beschriebenen Reaktionsbedingungen zu einem Novolakharz mit einer Viskosität von 950 mPa x s (40%ig in Methoxypropanol) und einer Glastemperatur von 123° C umgesetzt.

Anwendung

Die Bindemittel aus Vergleichsbeispiel 3 werden analog zu Beispiel 1 in Resistlösungen eingesetzt und gemäß diesem Beispiel weiterverarbeitet. Die Dunkelabträge wurden zu 249 nm/min (a) und 135 nm/min (b) bestimmt.

Beispiel 3

Analog zur Herstellung des Novolaks aus Beispiel 1 werden Gemische aus 9 mol m-Kresol und 1 mol 2,3,6-Trimethylphenol mit unterschiedlichen Mengen Formaldehyd (Molverhältnis Phenolkomponenten zu Formaldehyd wie in Tabelle 2 angegeben) und Oxalsäure als Katalysator zu Novolakharz kondensiert. Die gemessenen Viskositätswerte (40%ig in Methoxyropanol) sind in Tabelle 2 zusammengestellt.

Vergleichsbeispiel 4

Wie bei Beispiel 1 beschrieben, werden Gemische aus 9 mol m-Kresol und 1 mol 2,3,5-Trimethylphenol mit unterschiedlichen Mengen Formaldehyd (Molverhältnis Phenolkomponenten zu Formaldehyd wie in Tabelle 2 angegeben) zu Novolakharzen kondensiert. Die Viskositäten (40%ig in Methoxypropanol) der Novolakharze sind in Tabelle 2 angegeben.

Es zeigt sich, daß Novolak-Harze, die 2,3,5-Trialkylphenole neben m-Kresol enthalten, wesentlich größere Schwankungsbreiten hinsichtlich ihrer Viskosität bei Variation des Formaldehyd-Einstands aufweisen, als Harze, die anstelle dieser 2,3,6-Trialkylphenole enthalten. Insbesondere ist die Viskosität annähernd konstant, wenn der Formaldehyd-Einstand im Bereich 0,85 bis 0,95 mol, insbesondere von 0,89 bis 0,92 mol/mol Phenolkomponente variiert. Als "konstante" Viskosität ist demnach eine Variationsbreite ($\Delta$) innerhalb der Grenzen des Formaldehyd-Einstands von maximal 200 mPa x s anzusehen.

7

Tabelle 1

| Novolakharz | Zusammensetzung des Phenolgem. (in mol %) | Viskosität 40%ig in MP (mPa x s) | Glastemperatur (° C) | Dunkelabtrag (nm/min) | | Wärmestand: Veränderungen der Kantenprofile |
|---|---|---|---|---|---|---|
| Beispiel 1 | 90 m-Kresol 10 2,3,6-Tri-methylphenol | 630 | 119 | (a) (b) | 58 47 | keine |
| Beispiel 2 | 80 m-Kresol 20 2,3,6-Tri-methylphenol | 495 | 117 | | 18 | keine |
| Vergleichs-beispiel 1 | 90 m-Kresol 10 2,4-Dime-thylphenol | 615 | 118 | (a) (b) | 272 351 | keine |
| Vergleichs-beispiel 2 | 90 m-Kresol 10 2,6-Dime-thylphenol | 690 | 116 | (a) (b) | 289 365 | keine |
| Vergleichs-beispiel 3 | 100 m-Kresol | 950 | 123 | (a) (b) | 249 135 | keine |

# EP 0 335 220 B1

Tabelle 2

| Novolakharz | Zusammensetzung des Kresolgemischs in mol % | | Formaldehyd-Einstand in mol CH$_2$O pro mol Phenolkomponente | Viskosität des Novolaks in 40%igem Methoxypropanol |
|---|---|---|---|---|
| Beispiel 3 a) | 90 m-Kresol | 10 2,3,6-Tri-methylphenol | 0,895 | 510 mPa x s |
| 3 b) | | | 0,903 | 630 mPa x s |
| 3 c) | | | 0,910 | 625 mPa x s |
| 3 d) | | | 0,918 | 690 mPa x s |
| Vergleichs-beispiel 4 a) | 90 m-Kresol | 10 2,3,5-Tri-methylphenol | 0,860 | 500 mPa x s |
| 4 b) | | | 0,868 | 550 mPa x s |
| 4 c) | | | 0,871 | 640 mPa x s |
| 4 d) | | | 0,877 | 950 mPa x s |
| 4 e) | | | 0,890 | 1.065 mPa x s |

## Patentansprüche

1. Positiv arbeitendes lichtempfindliches Gemisch, enthaltend als lichtempfindliche Verbindung ein o-Chinondiazid sowie ein in Wasser unlösliches, in wäßrigem Alkali aber lösliches Bindemittel vom Novolak-Typ, dadurch gekennzeichnet, daß das Bindemittel aus einem Gemisch enthaltend ein m-Kresol und ein 2,3,6-Trialkylphenol, hergestellt worden ist.

2. Lichtempfindliches Gemisch nach Anspruch 1, dadurch gekennzeichnet, daß das Gemisch zur Herstellung des Novolaks 75-95 mol-% m-Kresol und 5-25 mol-% 2,3,6-Trialkylphenol enthält.

3. Lichtempfindliches Gemisch nach den Ansprüchen 1 bis 2, dadurch gekennzeichnet, daß das Novolakharz eine Glastemperatur von mindestens 110° C, insbesondere von mindestens 115° C, aufweist.

9

**4.** Lichtempfindliches Gemisch nach einem oder mehreren der Ansprüche 1 bis 3, dadurch gekennzeichnet, daß das 2,3,6-Trialkylphenol 2,3,6-Trimethylphenol ist.

**5.** Lichtempfindliches Gemisch nach einem oder mehreren der Ansprüche 1 bis 4, dadurch gekennzeichnet, daß als o-Chinondiazide Ester oder Amide von o-Naphtho- oder o-Benzochinondiazidsulfonsäuren eingesetzt werden.

**6.** Lichtempfindliches Gemisch nach Anspruch 5, dadurch gekennzeichnet, daß es sich um Ester von o-Naphthochinondiazid-4- oder -5-sulfonsäuren mit Mono- oder Polyhydroxybenzophenonen oder -acyclophenonen handelt.

**7.** Lichtempfindliches Gemisch nach einem oder mehreren der Ansprüche 1 bis 6, dadurch gekennzeichnet, daß das Gemisch auf 100 Gewichtsteile Novolakharz 5 bis 100 Gewichtsteile des o-Chinondiazides enthält.

**8.** Positiv arbeitendes Aufzeichnungsmaterial für die Leiterplattenherstellung, zur Herstellung mikroelektronischer Bauelemente und zur Herstellung von Offsetdruckplatten, im wesentlichen bestehend aus einem Träger und einer lichtempfindlichen Schicht, dadurch gekennzeichnet, daß die Schicht aus einem lichtempfindlichen Gemisch gemäß den Ansprüchen 1 bis 7 hergestellt ist.

**9.** Verfahren zur Herstellung eines positiv arbeitenden Aufzeichnungsmaterials nach Anspruch 8, dadurch gekennzeichnet, daß ein lichtempfindliches Gemisch gemäß den Ansprüchen 1 bis 7 auf einen ggf. mit einem Haftvermittler beaufschlagten Träger aufgebracht wird und anschließend das Material getrocknet wird.

**Claims**

**1.** A positiv-working photosensitive mixture comprising an o-quinonediazide as the photosensitive compound and a binder of the novolak type which is insoluble in water and soluble in aqueous-alkaline media, characterized in that the binder is prepared from a mixture containing an m-cresol and a 2,3,6-trialkylphenol.

**2.** Photosensitive mixture as claimed in claim 1, characterized in that the mixture from which the novolak is prepared contains 75 to 95 mol-% of m-cresol and 5 to 25 mol-% of 2,3,6-trialkylphenol.

**3.** Photosensitive mixture as claimed in claims 1 and 2, characterized in that the novolak resin has a glass transition temperature of at least 110°C, preferably of at least 115°C.

**4.** Photosensitive mixture as claimed in one or several of claims 1 to 3, characterized in that the 2,3,6-trialkylphenol is 2,3,6-trimethylphenol.

**5.** Photosensitive mixture as claimed in one or several of claims 1 to 4, characterized in that esters or amides of o-naphthoquinonediazide sulfonic acids or of o-benzoquinonediazide sulfonic acids are used as o-quinonediazides.

**6.** Photosensitive mixture as claimed in claim 5, characterized in that esters of o-naphthoquinonediazide-4- or -5-sulfonic acids with mono- or polyhydroxybenzophenones or -acyclophenones are employed.

**7.** Photosensitive mixture as claimed in one or several of claims 1 to 6, characterized in that 5 to 100 parts by weight of o-quinonediazide are contained in said mixture per 100 parts by weight of novolak resin.

**8.** Positive-working recording material suitable for the production of printed circuits boards, microelectronic component parts and offset printing plates, which is essentially comprised of a support coated with a photosensitive layer, characterized in that said layer is prepared from a photosensitive mixture as claimed in claims 1 to 7.

9. Process for the preparation of a positive-working recording material as claimed in claim 8, characterized in that a photosensitive mixture as claimed in claims 1 to 7 is applied to a support which is optionally provided with an adhesion-promoting coating, and that the material is subsequently dried.

**Revendications**

1. Composition photosensible travaillant en positif, contenant comme composé photosensible un o-quinonediazide ainsi qu'un liant du type résine novolaque, insoluble dans l'eau mais soluble en milieu alcalin aqueux, composition caractérisée en ce que le liant est préparé à partir d'un mélange d'un m-crésol et d'un 2,3,6-trialkylphénol.

2. Composition photosensible selon la revendication 1, caractérisée en ce que le mélange pour la fabrication de la novolaque contient 75 à 95 % en moi es de m-crésol et 5 à 25 % en moles de 2,3,6-trialkylphénol.

3. Composition photosensible selon la revendication 1 ou 2, caractérisée en ce que la résine novolaque présente une température de transition vitreuse d'au moins 110 ° C, en particulier d'au moins 115 ° C.

4. Composition photosensible selon une ou plusieurs des revendications 1 a 3, caractérisée en ce que le 2,3,6-trialkylphénol est le 2,3,6-triméthylphénol.

5. Composition photosensible selon une ou plusieurs des revendications 1 à 4, caractérisée en ce qu'on utilise comme o-quinonediazides des esters ou ami des d'acides o-naphto- ou o-benzoquinonediazidesulfoniques.

6. Composition photosensible selon la revendication 5, caractérisée en ce qu'il s'agit d'esters d'acides o-naphtoquinonediazide-4- ou -5-sulfoniques avec des mono- ou polyhydroxybenzophénones ou -acyclophénones.

7. Composition photosensible selon une ou plusieurs des revendications 1 a 6, caractérisée en ce que la composition contient 5 a 100 parties en poids de l'o-quinonediazide pour 100 parties en poids de résine novolaque.

8. Matériau reprographique travaillant en positif, pour la fabrication de circuits imprimés, de composants microélectroniques et de plaques d'impression offset, comprenant essentiellement un support et une couche photosensible, caractérisé en ce que la couche est obtenue à partir d'une composition photosensible selon les revendications 1 à 7.

9. Procédé de fabrication d'un matériau de reprographie travaillant en positif, selon la revendication 8, caractérisé en ce qu'on dépose une composition photosensible selon les revendications 1 à 7 sur un support éventuellement recouvert d'un promoteur d'adhérence, et qu'on sèche ensuite ledit matériau.